Europäisches Patentamt

European Patent Office

Office européen des brevets

(11) Publication number: **0 061 811**
**B1**

## (12) EUROPEAN PATENT SPECIFICATION

(45) Date of publication of patent specification: **17.07.85**

(21) Application number: **82200351.3**

(22) Date of filing: **23.03.82**

(51) Int. Cl.⁴: **H 01 R 43/00**

(54) Device for positioning an electric cord and mounting a plug at an end thereof.

(30) Priority: **30.03.81 NL 8101540**

(43) Date of publication of application:
**06.10.82 Bulletin 82/40**

(45) Publication of the grant of the patent:
**17.07.85 Bulletin 85/29**

(84) Designated Contracting States:
**AT CH DE FR GB LI NL SE**

(56) References cited:
**DE-A-2 829 015**
**GB-A-1 295 632**

(73) Proprietor: **N.K.F. Groep B.V.**
**J.C. van Markenlaan 5**
**NL-2285 VL Rijswijk (NL)**

(72) Inventor: **Deurloo, Johannis Martinis**
**c/o INT. OCTROOIBUREAU B.V. Prof. Holstlaan 6**
**NL-5656 AA Eindhoven (NL)**

(74) Representative: **Weening, Cornelis et al**
**INTERNATIONAAL OCTROOIBUREAU B.V. Prof.**
**Holstlaan 6**
**NL-5656 AA Eindhoven (NL)**

Courier Press, Leamington Spa, England.

## Description

The invention relates to a device for positioning an electric cord and mounting a plug at an end thereof, said cord carrying within a common insulation, two or more insulated conductors, one of which is provided with auxiliary means by which it has a magnetic permeability which differs from that of the other insulated conductor(s), said device comprising a magnetic detector to locate the position of the insulated conductor having the auxiliary means.

Such a device is known from the British Patent Specification 1.295.632. According to said British patent a three-phase cable comprising three insulated phase conductors is coupled to a T-connection. Thereby the position of each phase conductor can be determined. The cable is provided with a ferro-magnetic element, conveniently an iron wire, located preferably between two of the phase conductors and possibly within one of the conductors. The device for determining the position of the conductors comprises a magnetic detector by which the position of the iron wire is determined and as a result also the position of the conductors. The magnetic detector comprises rotatable magnets. The magnetic detector in operation is rotated manually as a whole around the cable. When the magnet system is radially aligned with the ferro-magnetic filament, the magnets will rotate, an electric circuit will be closed and a lamp will lighten. A work station is provided for positioning a tool for working on the cable conductors, thus determined and located.

This known device has a rather complicated structure and is operated manually. Therefor the said device is not suitable for modern mass production techniques.

From the German Offenlegungsschrift 28 29 015 a device is known for automatic coupling of an electric cable to a coupling contact such as a plug. It is said that the position of the conductors of the cable is determined in an electro-optical manner. No details are given. According to the experience of applicant an electro-optical detection easily can lead to faults, is dependent upon the type of colours used and has a low degree of reliability.

It is an object of the present invention to provide a device by which the position of the conductors of an electric cord is determined fully automatically and with a high degree of reliability so as to mount a plug.

This object is achieved with a device of the type described in the opening paragraph which is characterized in that the magnetic detector is connected electrically to a driving mechanism for rotation of the electric cord, that the device comprises a clamping member to fix the position of the electric cord and that means are present to provide a plug at the end of the fixed electric cord.

In a favourable embodiment the magnetic detector is connected to the driving mechanism via a memory element.

In another favourable embodiment the driving mechanism is a stepping motor comprising a shaft having teeth coupled to a sliding element, which comprises two spaced-apart parallel guide rails which extend at some distance from each other and which are movable relative to each other and on their mutually facing surfaces comprise teeth which co-operate with the teeth of the shaft of the stepping motor.

The auxiliary means applied to one of the conductors may consist of particles with a high magnetic permeability such as ferrite particles dispersed in the insulation mantle of said one conductor. Preferably the auxiliary means are formed by one or more wires having a magnetic permeability different from that of the conductors. Such wires are for example steel wires positioned inside the insulation mantle of the said conductor. The conductor provided with the auxiliary means, normally is the earth conductor to be connected to the earth pin of the plug.

The device for detecting the magnetic permeability is of a conventional type and in a simple embodiment comprises an electric coil. Alternatively a so-called Hall generator may be used which is a semiconductor element for determining magnetic field strengths. The end of the cord to which the plug is connected is introduced into the detection device. The outer cover of said end may or may not be removed over a small length of, for example, a few centimetres. In a suitable practical embodiment the outer cover is removed over a length of 2 to 3 cm and the ends of the insulated conductors are clamped. The clamped conductors are rotated in the recording device, and it is then established in which rotary position of the cord with clamped conductors the detection device gives a previously adjusted signal. Herewith the location of the insulated conductor provided with one or more auxiliary wires, in particular the earth wire, is known. The relevant signal may be based on the detection or recording of a maximum magnetic flux, which means that the earth conductor is present at a minimum distance from the electric coil of the detection device and, for example, is the uppermost of three insulated conductors. The signal may alternatively be tuned to the recording of a minimum flux, in which the earth conductor is in a lowermost position.

In the above-mentioned rotary position, i.e. the position with known location of the earth wire, the cord is fixed and then provided with a plug in a usual mechanical manner.

Such a method is known, for example, from French Patent Specification 2,282,772, German Auslegeschrift 1,132,615 and German Offenlegungsschrift 1,515,753. According to the known method the insulation cover of each insulated conductor is cut away over a small length and a contact sleeve or pin is mounted on the exposed conductors. The housing manufactured from a synthetic resin is then provided by interconnecting the composing parts of the housing, usually two parts, while enclosing the contact pins and sleeves. A frequently used connection is a snap fastener, a glued joint or a connection obtained by fusion. A housing of synthetic resin moulded around the pins or sleeves is also possible.

The cord set obtained in this manner can be measured electrically in a simple and efficacious manner by localizing the earth wire at the fee end of the cord in the above-described manner by means of the detection device for magnetic permeability, and then setting up an electric voltage across the earth wire. An electric voltage must be observed at the other end of the cord on the pin or brace which is connected to the earth wire.

The invention will now be described in greater detail by means of the drawing, in which

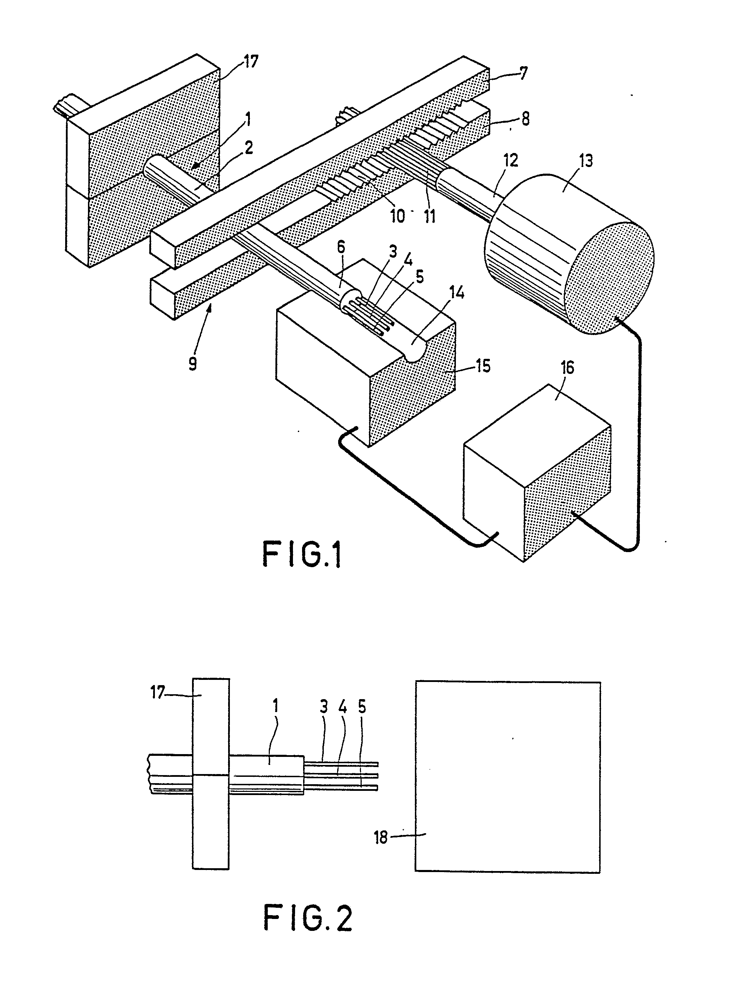

Figures 1 and 2 show diagrammatically the device according to the invention.

Reference numeral 1 in Figure 1 denotes an electric cord which comprises three insulated conductors 3, 4, 5 within an outer cover 2. Each insulated conductor consists of a conductive core which is a litz wire of 20 elementary wires of tin-plated copper each having a diameter of 0.2 mm, surrounded by an insulation of synthetic resin. One of the insulated conductors, for example conductor 3, has a conductive core which in addition to the 20 copper wires also comprises one steel wire having a diameter of 0.20 mm. At one end 6 of the electric cord 1 the outer cover has been removed over a length of 2 to 3 cm. Cord 1 is held between two parallel spaced-apart guide rails 7, 8 of a sliding element 9. The mutually facing surfaces of guide rails 7, 8 are provided over a part of the length with teeth 10 in which the teeth 11 of a shaft 12 of stepping motor 13 engage. By rotation of shaft 12, rails 7, 8 move relative to each other so that the clamped cord 1 is also rotated. The end 6 of cord 1 is present in the measuring slot 14 of the magnetic detector 15, in this case an electric coil.

For reasons of clarity the insulated conductors 3, 4 and 5 extending in the measuring slot 14 are shown to be in a parallel position. In practice the conductors 3, 4 and 5 together will have a triangular to circular cross-section. The magnetic detector 15 is connected to stepping motor 13 via a memory element 16. The operation of the device is as follows.

The outer cover 2 of cord 1 is removed over a length of a few centimetres and, via sliding element 7 in which the cord is guided between rails 7, 8, the cord is introduced into the magnetic detector 15 in such manner that the end 6 of cord 1 lies in the measuring slot 14 with the ends of the conductors 3, 4, 5. The stepping motor 13 is coupled to sliding element 9 in which teeth 11 on shaft 12 of motor 13 co-operate with teeth 10 of the rails 7, 8. Stepping motor 13 is actuated, shaft 12 being rotated stepwise over 360° by small steps. As a result of this, rails 7, 8 move relative to each other, the clamped cord 1 being also rotated through 360°. During said rotation the insulated conductor 3 in measuring slot 14 provided with a steel wire will pass a previously adjusted measuring position, for example, a lowermost position. The angular rotation, that is the number of arc degrees necessary to reach the measuring position, is recorded and stored in the memory element 16. After the above-mentioned rotation over 360° the cord 1 is again in the initial position and by means of the stepping motor 13 it is then rotated back, according to the indication of the information stored in the memory element 16, over the above-mentioned number of arc degrees which was necessary during the first rotation to reach the measuring position. In this position of the cord 1 the insulated conductor 3 (earth wire) provided with a steel wire is at the required location for mounting to a plug. The cord 1 is held fixed in this position by means of the clamping member 17 after which the clamped cord, with the earth wire in the required location, is introduced into the known device 18 for mounting a plug to the fixed cord end (Figure 2).

The other end of cord 1 not shown in Figure 1 is treated in the same manner as described above. At this other end, the position of the insulated conductor (earth wire) comprising a steel wire is also determined. A coupling plug or appliance plug may then be mounted to said other end, with the fixed position of the earth conductor, in the usual manner, in which of course the earth wire is connected to the earth plug or earth pin of the plug. The cord set can be measured by applying a voltage to the earth brace of the plug at one or both ends, which voltage has to be observed on the earth pin of the plug of the other end.

A cord set obtained by a device according to the invention and having a plug at only one end is measured by first determining the position of the earth wire at the free cord end, then applying a voltage to the earth conductor, and finally checking the earth pin of the contact plug for the presence of voltage.

## Claims

1. A device for positioning an electric cord (1) and mounting a plug at an end thereof, said cord carrying within a common insulation (2), two or more insulated conductors (3—5) one of which is provided with auxiliary means by which it has a magnetic permeability which differs from that of the other insulated conductor(s), said device comprising a magnetic detector (15) to locate the position of the insulated conductor having the auxiliary means, characterized in that the magnetic detector (15) is connected electrically to a driving mechanism (13) for rotation of the electric cord (1), that the device comprises a clamping member (17) to fix the position of the electric cord (1) and that means (18) are present to provide a plug at the end of the fixed electric cord.

2. A device as claimed in claim 1, characterized in that the magnetic detector (15) is connected to the driving mechanism (13) via a memory element (16).

3. A device as claimed in Claim 1 or 2, characterized in that the driving mechanism (13) is a stepping motor comprising a shaft (12) having teeth (11) coupled to a sliding element (9) which comprises two spaced-apart parallel guide rails (7, 8) and which are movable relative to each other and on their mutually facing surfaces comprise teeth (10) which engage the teeth (11) of the shaft (12) of the stepping motor (13).

## Revendications

1. Dispositif pour le positionnement d'un cordon électrique et le montage d'une prise à l'une des ses extrémités, ledit cordon présentant au moins deux conducteurs isolés (3—5) prévus dans une isolation commune (2), conducteurs dont l'un est muni de moyens auxiliaires à l'aide desquels il présente une perméabilité magnétique différant de celle de l'autre conducteur isolé ou des autres conducteurs isolés, dispositif comportant un détecteur magnétique permettant de localiser la position du conducteur isolé présentant les moyens auxiliaires, caractérisé en ce que le détecteur magnétique (15) est connecté électriquement à un mécanisme d'entraînement (13) pour la rotation du cordon électrique (1), que le dispositif comporte un organe de serrage (17) de fixer la position du cordon électrique (1) et que des moyens (18) sont présents pour monter une prise à l'extrémité du cordon électrique fixé.

2. Dispositif selon la revendication 1, caractérisé en ce que le détecteur magnétique (15) est connecté à un mécanisme d'entraînement (13) par l'intermédiaire d'un élément de mémoire (16).

3. Dispositif selon la revendication 1 ou 2, caractérisé en ce que le mécanisme d'entraînement (13) est un moteur pas-à-pas comportant un arbre (12) présentant des dents (11) couplées à un élément de glissement (9), qui comporte deux rails de guidage espacés parallèles (7, 8) qui peuvent être déplacés l'un par rapport à l'autre et comportent des dents (10) prévues sur leurs surfaces situées en regard, qui s'engagent sur les dents (11) de l'arbre (12) du moteur pas-à-pas (13).

## Patentansprüche

1. Vorrichtung zur Positionierung einer elektrischen Leitung (1) und zur Montage eines Steckers an deren Ende, wobei diese Leitung innerhalb einer gemeinsamen Isolierung (2) zwei oder mehr isolierte Leiter (3—5) aufweist, von denen einer mit einem Hilfsmittel versehen ist, durch das dieser Leiter eine magnetische Permeabilität aufweist, die von der (des) der anderen isolierten Leiter(s) abweicht, wobei diese Vorrichtung einen magnetischen Detektor (15) aufweist zum Orten der Lage des isolierten Leiters mit dem Hilfsmittel, dadurch gekennzeichnet, dass der magnetische Detektor (15) mit einem Antreibsmechanismus (13) zum Drehen der elektrischen Leitung (1) elektrisch verbunden ist, dass die Anordnung ein Klemmelement (17) aufweist zum Fixieren der Lage der elektrischen Leitung (1) und dass Mittel (18) vorhanden sind um an dem Ende der fixierten elektrischen Leitung einen Stecker zu montieren.

2. Vorrichtung nach Anspruch 1, dadurch gekennzeichnet, dass der magnetische Detektor (15) über ein Speicherelement (16) mit dem Antriebsmechanismus (13) verbunden ist.

3. Vorrichtung nach Anspruch 1 oder 2, dadurch gekennzeichnet, dass der Antriebsmechanismus (13) ein Schrittmotor mit einer Welle (12) mit Zähnen (11) ist, die mit einem Schiebeelement (9) gekuppelt ist, das zwei in einem Abstand voneinander liegende sich parallel zueinander erstreckende Führungsschienen (7, 8) aufweist, die gegenübereinander beweglich sind und an den einander zugewandten Flächen Zähne (10) aufweisen, die mit den Zähnen (11) der Welle (12) des Schrittmotors (13) zusammenarbeiten.

0 061 811

FIG.1

FIG.2